(19) Europäisches Patentamt

European Patent Office

Office européen des brevets

(11) **EP 1 337 044 A2**

(12) **EUROPEAN PATENT APPLICATION**

(43) Date of publication:
**20.08.2003 Bulletin 2003/34**

(51) Int Cl.⁷: **H03M 13/15**, G06F 11/08

(21) Application number: **02027412.2**

(22) Date of filing: **09.12.2002**

(84) Designated Contracting States:
**AT BE BG CH CY CZ DE DK EE ES FI FR GB GR
IE IT LI LU MC NL PT SE SI SK TR**
Designated Extension States:
**AL LT LV MK RO**

(30) Priority: **14.02.2002 JP 2002036796**

(71) Applicant: **MATSUSHITA ELECTRIC INDUSTRIAL
CO., LTD.
Kadoma-shi, Osaka 571-0050 (JP)**

(72) Inventor: **Sekiguchi, Hiroyuki
Yokohama-shi, Kanagawa 233-0002 (JP)**

(74) Representative: **Grünecker, Kinkeldey,
Stockmair & Schwanhäusser Anwaltssozietät
Maximilianstrasse 58
80538 München (DE)**

(54) **Code generator circuit**

(57) A code generator circuit according to the invention comprises a divider circuit configured as a shift register where flip-flops F1-F8, selectors 130-137, and exclusive-OR circuits 110, 111, 112, 113 are serially connected, and a division remainder decision circuit 101 including a remainder shift circuit that compares the number of digits of leading 0s of the value on the shift register with the number of leading 0s of the subsequent input data and assumes the number of digits of the smaller as the number of skip digits, then outputs the value on the shift register shifted by the number of skip digits, characterized in that the selector circuits select the output of the remainder shift circuit when the number of skip digits is 1 or more and select the output of the flip-flops connected immediately before the respective selector circuits when the number of skip digits is 0

FIG.1

**Description**

BACKGROUND OF THE INVENTION

The present invention relates to a code generator circuit that generates cyclic codes by using generator polynomials.

Cyclic codes generated by using generator polynomials have been subject to a great number of researches and technical developments. A variety of codes are used in wide applications such as telecommunications and digital media recording.

Assuming a generator polynomial having the degree b as G(X), a polynomial using a-bit coding-target data as a coefficient as I(X), the quotient obtained by dividing I(X) by G(X) as Q(X), and the remainder as R(X) by using a polynomial expression on the Galois field GF (2), the operation is represented in $I(X)X^b=Q(X)G(X)+R(X)$, abbreviating the times sign and assuming ^ as the exponentiation sign.

The coefficient of $I(X)X^b+R(X)$ is a codeword of a cyclic code generated from the coding-target data and comprises a bits as coding-target data coupled with each coefficient b bits of R(X). Thus, in order to generate a codeword, it is necessary to perform division operation where a polynomial P(X) using coding-target data as a coefficient multiplied by $X^b$ is divided by a generator polynomial G(X) to obtain the remainder R(X).

Concerning a divider circuit for obtaining the remainder, the following procedure is described for example in "Coding Theory" by Hideki Imai (Society of Electronics, Information and Communications).

    Step 1: Assume S(X)=0 as an initial value.
    Step 2: Ender one coefficient of P(X) in order and multiply it by $X^b$.
    Step 3: Add S(X)X to the value obtained.
    Step 4: Divide the value by G(X).
    Step 5: Assume the remainder obtained in operation in step 4.
    Step 6: Repeat steps 2 through 5 and when there is no coefficients of the P(X) to be input, assume S(X) obtained as R(X).

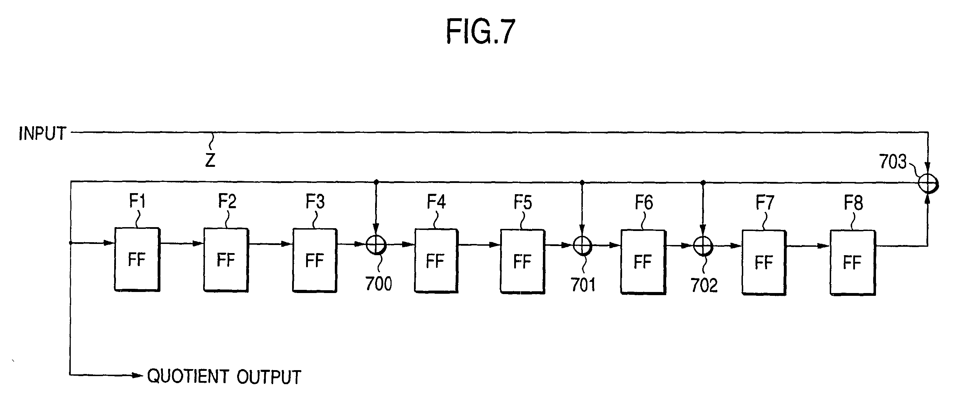

Fig. 7 is a circuit diagram showing the example of a related art divider circuit for executing the aforementioned procedure. In Fig. 7, F1 through F8 represent flip-flops configured as a shift register and 707-703 exclusive-OR circuits. The generator polynomial in this embodiment is $G(X)=X^8+X^6+X^5+X^3+1$.

When 1-bit data z is input to the divider circuit in order from the a-bit input data to be coded, the data z is multiplied by $X^8$ in the exclusive-OR circuit 703 then added to a value a value obtained by shifting the flip-flops by one bit. The resulting value is used as a quotient output. Then division is performed using G(X) by the exclusive-OR circuits 700 through 702. When the final data has been input, a value remaining in the shift register is assumed as a remainder R(x).

In the related art divider circuit, the time required to obtain a remainder is the time required for all the a-bit input data to be input and **a** times the shift clock cycle. In generation of various codewords, respective coding-target data often has certain characteristics. Thus it may be possible to reduce the division time by utilizing the characteristics of the coding-target data input to a divider circuit.

While efforts have been made, such as reducing the total operation time through parallel operation in order to reduce the division time in a code generator circuit, there have been no general methods for reducing the division time by utilizing the characteristics of the coding-target data to be input.

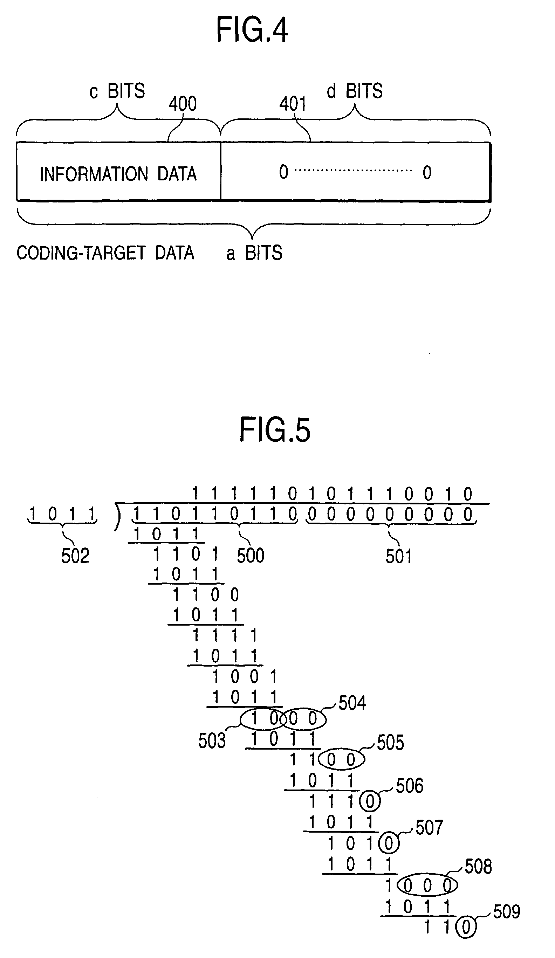

As an example of coding-target data having specific characteristics, data shown in Fig. 4 will be described. In Fig. 4, a-bit coding-target data is comprises c-bit random information data 400 and additional part 401 comprising d-bit 0s. Among various coding-target data is data having such a structure. An additional part 401 comprising successive 0s may reach several hundreds of bits.

The division method using the related art divider circuit for performing division to generate codewords for data having such characteristics will be examined using specific values as shown in Fig. 5. In Fig. 5, for simplicity, the coding-target data comprises 8-bit information data plus 10-bit 0s and the generator polynomial is $(X)=X^3+X+1$.

Assume codeword generation for information data "11011011" represented by a numeral 500. This means dividing of the dividend "110110110000000000" with 10-bit 0s shown by 501 added by G(X) or the dividend "1011" represented by 502 and obtaining a remainder.

The remainder obtained by dividing the 8-bit information data part represented by 500 becomes "010" represented by 503. In the subsequent division, a value obtained by adding 10-bit 0s to the remainder of the immediately preceding step is divided, as shown in numerals 504 through 509. In 504, 505 and 508, the quotient of division is 0 and the remainder bit value stays unchanged when only 1-bit 0 is added. Thus, 0s are added for 2 bits or more until the quotient reaches 1.

Considering this procedure in the context of the divider circuit in Fig. 7, when c-bit information data has been input and the remaining input data is d-bit 0s, in case the first bit of S(X) as an intermediate result of remainder calculation is 0, or F8 is 0, the quotient is 0 and division operation only carries out a simple shift operation and inputs 0 in the least significant bit. In case this state continues, the division repeats simple shift operation of the shift register. It is understood that, when input data z is 0, the remainder n-bit value changes only in case the quotient becomes 1, that is, F8 becomes 1.

In this way, even in a situation where only simple shift operation is required instead of step-based division of input data depending on the operation state, the related art method required d-bit shift operation to calculate a remainder necessary for generating a codeword. In the related art method, the operation time for shift operation of $a$ bits as the number of bits of the coding-target data was required in dividing the data shown in Fig. 4 by a generation polynomial to calculate a remainder.

SUMMARY OF THE INVENTION

The invention has been proposed in view of this problem and aims at providing a code generator circuit for generating cyclic codes capable of considering the characteristics of input data thus reducing the division time.

A code generator circuit according to the first aspect of the invention is a code generator circuit for dividing input data input to a bit serial by a predetermined generator polynomial to generate a division remainder, comprising division means configured as a shift register where a plurality of flip-flops (F1-F8), selector circuits (selectors 130-137) respectively added immediately after the flip flops, and exclusive-OR circuits (110, 111, 112, 113) inserted according to the generator polynomial are serially connected, andmeans (division remainder decision circuit 101) including a remainder shift circuit for comparing the number of digits of leading 0s (number of digits of successive 0s from the data head) of the value on the shift register with the number of leading 0s of the subsequent input data, assuming the number of digits of the smaller as the number of skip digits, then outputting the value on the shift register shifted by the number of skip digits, in that the selector circuits select the output of the remainder shift circuit when the number of skip digits is 1 or more and select the output of the flip-flops connected immediately before the respective selector circuits when the number of skip digits is 0.

With the code generator circuit according to the first aspect, the quotient output of the divider circuit becomes 0 by obtaining the number of skip digits based on the number of leading 0s of the remainder in the middle of the division and the number of leading 0s of the subsequent input data, and by using a value obtained by shifting the value on the shift register by the number of skip digits in case the number of skip digits is 1 or more in the division operation. Thus it is possible to skip the simple shift processing not requiring division operation thereby reducing the division time depending on the input data and the remainder in the middle of division.

According to the second aspect of the invention, the code generator circuit further comprises count means (counter 201) for counting the number of shifts of the shift register and decision means (division remainder generation end decision circuit 212) for detecting that the count means has counted the number of skip digits additionally in case the selector circuits have selected the output of the remainder shift circuit and detecting that the count means has counted up to a value equal to the total number of digits of the input data to terminate the generation of division remainder.

With the code generator circuit according to the second aspect of the invention, it is possible to count the number of shifts of the shift counter and correct the count value of the number of input digits of input data by using the number of skip digits. Thus it is possible to constantly check the correct number of input digits of input data, thereby properly determining the end of generation of division remainder.

A code generator circuit according to the third aspect of the invention comprises storage means (FF310-FF318) for storing the quotients obtained by dividing the input data by the generator polynomial, in that, in case the selector circuits have not selected the output of the remainder shift circuit, the code generator circuit sets the quotient output of the divider circuit to the digit position of the storage means corresponding to the digit position of the input data and, in case the selector circuits have selected the output of the remainder shift circuit, inserts 0s as many as the number of the skip digits than sets the quotient output of the divider circuit to the digit position of the storage means corresponding to the digit position of the input data.

With the code generator circuit according to the third aspect, it is possible to set the quotient output onto the storage means in correspondence with the digit position of input data, and also insert 0s as many as the number of skip digits into the skipped bit position even when the simple shift processing not requiring division is skipped. This obtains the quotient of correct division.

BRIEF DESCRIPTION OF THE DRAWINGS

Fig. 1 is a circuit diagram showing a code generator circuit according to the first embodiment of the invention;
Fig. 2 is a circuit diagram showing the division remainder decision circuit in a ode generator circuit according to the first embodiment of the invention;
Fig. 3 is a circuit diagram showing a code generator circuit according to the second embodiment;
Fig. 4 is a configuration example of coding-target data having characteristics of information data and additional 0s;
Fig. 5 explains the process of division of coding-target data having characteristics of information data and additional 0s;
Fig. 6 explains the operation of a remainder shift circuit in the code generator circuit according to the invention; and
Fig. 7 is a circuit diagram showing the embodiment of a related art divider circuit.

## DETAILED DESCRIPTION OF THE PREFERRED EMBODIMENTS

Embodiments of the invention will be described referring to the drawings.

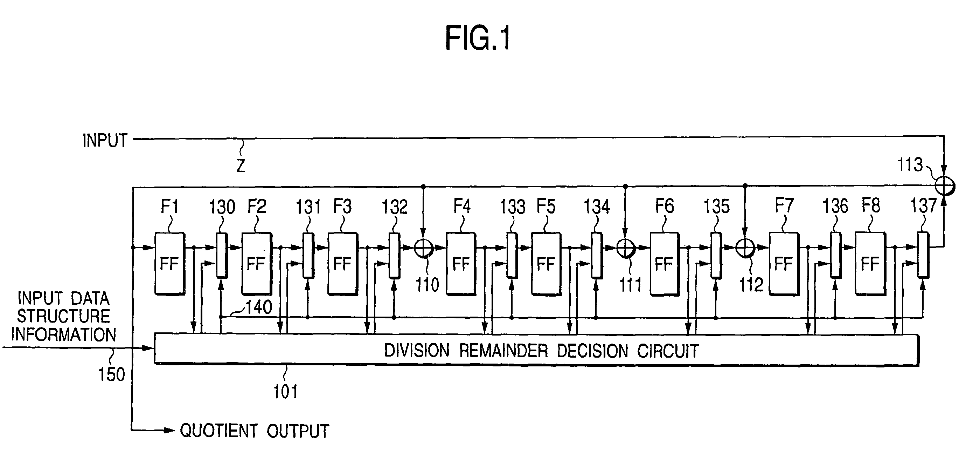

Fig. 1 is a circuit diagram showing a code generator circuit according to the first embodiment of the invention. In Fig. 1, F1 through F8 represent flip-flops configured as a shift register, 101 a division remainder decision circuit, 110 through 113 exclusive-OR circuits, 130 though 137 selector circuits for selecting the output of the flip-flops or output of the division remainder decision circuit 101, 140 a control signal from the division remainder decision circuit 101, 150 a signal to externally input the input data structure information. The generator polynomial in this circuit is $G(X)=X^8+X^6+X^5+X^3+1$.

In a code generator circuit configured as shown in Fig. 1, the division remainder decision circuit 101 detects the number of digits of leading 0s of the value on the shift register or flip-flops F8 through F1 and detects the number of digits of leading 0s of the subsequent input data, then compares the number of leading 0s of the subsequent input data with the number of digits of leading 0s of the value on the shift register and assumes the number of digits of the smaller as the number of skip digits, then switches over the selection of the selector circuits 130 through 137 by using the control signal 140 depending on whether the number of skip digits is 1 or more.

In case the number of skip digits is 0, the selector circuits 130 through 137 select the output of each flip-flop. In this case, the circuit in Fig. 1 is connected the same way as the divider circuit in Fig. 7 and operates the same as the divider circuit in Fig. 7. That is, 1-bit data z from input data is multiplied by $X^8$ in the exclusive-OR circuit 113 and added to a value obtained by shifting the flip-flops F8 through F1 by one bit. The resulting value serves as a quotient output, which is divided using $G(X)$ by the exclusive-OR circuits 110 through 112.

In case the number of skip digits is 1 or more, the selector circuits 130 through 137 select the output of the division remainder decision circuit 101. The division remainder decision circuit 101 outputs the value on the shift register shifted by the remainder shift circuit by the number of skip digits. It is guaranteed that the quotient output of division equals 0 until the value is shifted by the number of skip digits. In case the number of skip digits is 8, the digits on the shift registers are all 0 and the subsequent input data is successive eight-or-more-digit 0s. Thus the selector circuits 130 through 137 may select the output of each flip-flop.

In this practice, the input data is skipped as many as the number of skip digits. The subsequent input data z is multiplied by $X^8$ in the exclusive-OR circuit 113. Then the resulting value is added to a value obtained by shifting the flip-flops F8 through F1 output by the division remainder decision circuit 101 by the number of skip digits. The value thus obtained is used as the quotient output, which is then divided by $G(X)$ by the exclusive-OR circuits 100 through 112. In this way, when the input data z is 0, the simple shift processing that does not require division in order to obtain a quotient of 0 is skipped, so that processing to calculate a quotient of 1 may be entered.

An example of the shift operation used in case the input data is as shown in Fig. 4 will be explained. In this case, once the c-bit information data is input, the subsequent input data is all 0. At this time, the number of digits of leading 0s of the subsequent input data is equal to the remaining digits of the input data. For example, in case a circuit is provided for decrementing the number of digits of input data input from a counter where the number of all the digits of input data is set to a divider circuit in order to determine the end of generation of division remainder, it is possible, based on the counter value, to obtain the number of the remaining digits of the input data, or the number of digits of leading 0s of the subsequent input data.

For example, in case the content of the shift register is "00011010" at an arbitrary time after the c-bit information data is input, the flip-flops have values shown below.

F8=0, F7=0, F6=0, F5=1, F4=1, F3=0, F2=1, F1=0

The division remainder decision circuit 101 detects that the leading 0s are three digits, F8 through F6. Assuming that the number of remaining digits of input data is three or more, the value output by the division remainder decision circuit 101 is a value obtaining by shifting the flip-flops F8 through F1 by three digits as shown below.

Output[8]=F5=1, Output[7]=F4=0, Output[6]=F3=1, Output[5]=F2=1, Output[4]=F1=1, Output[3]=0, Output[2]=0, Output[1]=0

This gives $S(X)$ obtained after three divisions resulting in a quotient of 0. To $S(X)X$ obtained by shifting $S(X)$ by one bit is added the input data z multiplied by $X^8$ in the exclusive-OR circuit 113. Here, z is 0 so that the quotient output is 1 and division is made using $G(X)$ by the exclusive-OR circuits 110 through 112. This is processed with a single shift clock thus reducing the time equivalent to three shift clocks.

In case input data is as shown in Fig. 4, once the c-bit information data is input, it is possible to reduce the division time depending on the number of digits of leading 0s of the value appearing on flip-flops F8 through F1 when d-bit 0s are input.

While input data is as shown in Fig. 4 in the foregoing embodiment, it is possible to detect the same state in the middle of arbitrary division of arbitrary data and perform the same processing thus reducing the division time, according to the invention.

To apply the invention in the middle of division, a circuit is required for detecting the number of digits of leading 0s of the subsequent input data at an arbitrary time point. This circuit may be the same as the circuit for detecting the number of digits of leading 0s of the value on the shift register. A value exceeding the number of digits of the shift register is not necessary. Data within the range of the number of digits of the shift register from the head of the subsequent input data is required. The number of digits of leading 0s does not exceed the number of remaining digits of the input data. As a simple method, the output of the circuit for detecting the number of digits of leading 0s is compared with the number of remaining digits of the input data and the smaller is output as the number of digits of leading 0s detected.

A circuit is added for detecting the number of digits of leading 0s of the subsequent input data, and the output is compared with the number of digits of leading 0s of the value on the shift register and the smaller is determined as the number of skip digits. The selector circuits 130 through 137 select the output of the remainder shift circuit 101 when the number of skip digits is 1 or more and select the output of the flip-flops connected immediately before the respective selector circuits when the number of skip digits is 0.

In this way, according to this embodiment, it is possible to skip simple shift processing not requiring division operation in order to obtain a quotient of 0 when the input data z is 0 even in the middle of division of arbitrary data according to the invention. This can provide an excellent effect in case successive 0s frequently appear halfway depending on the characteristics of input data, thereby minimizing the division time.

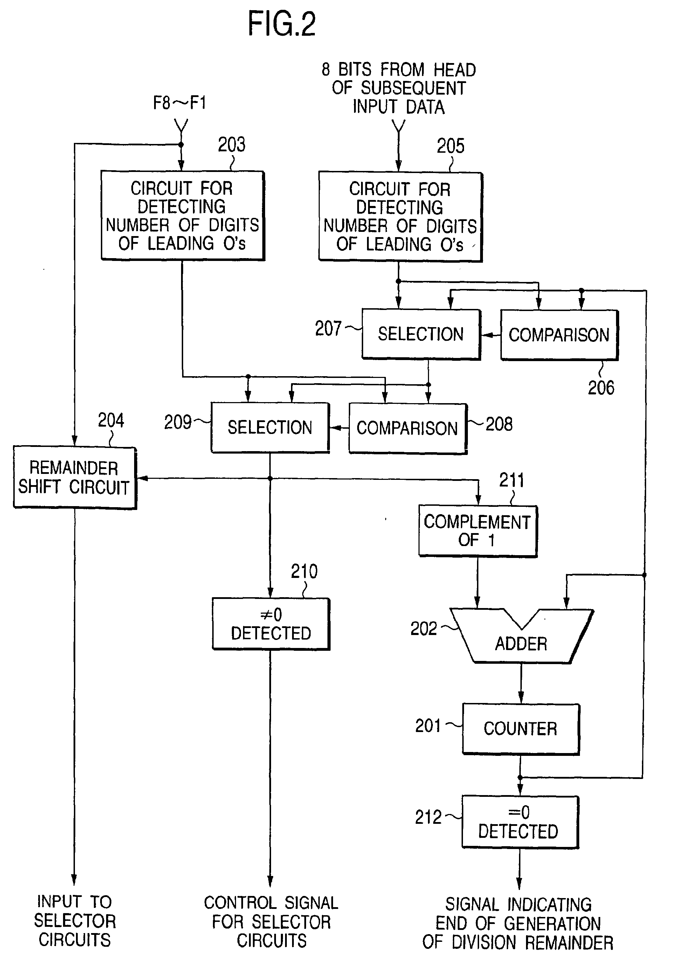

Fig. 2 is a circuit diagram showing the division remainder decision circuit 101. In Fig. 2, a numeral 201 represents a register used as a counter, 202 an adder for the counter, 203 a circuit for detecting the number of digits of leading 0s of the flip-flops F8 through F1 composing a shift register, 204 a remainder shift circuit for shifting the value on the shift register by the number of skip digits, 205 a circuit for detecting the number of digits of leading 0s of the subsequent input data, 206 a comparator circuit for comparing the value of the counter 201 with the output of the circuit for detecting the number of digits of leading 0s, 207 a selector circuit for selecting the smaller value of the value of the counter 201 and the output of the circuit 205 for detecting the number of digits of leading 0s based on the output of the comparator circuit 206, 208 a comparator circuit for comparing the output of the selector circuit 207 with the output of the circuit 203 for detecting the number of digits of leading 0s, 209 a selector circuit for selecting the smaller value of the output of the circuit 203 for detecting the number of digits of leading 0s and the output of the selector circuit 207, 310 a circuit for detecting that the output of the selector circuit 209 is not 0, 211 a complementer circuit of 1 for the output of the selector circuit 209, and 212 a circuit for detecting that the value of the counter 201n is 0.

The output of the selector circuit 209 gives the number of skip digits and controls the number of shift digits in the remainder shift circuit 204. The output of the selector circuit 210 indicates that the number of skip digits is 1 or more and given as a control signal 140 to the selector circuits 130 through 137.

By obtaining the complement of 1 of the number of skip digits in the complementer circuit of 1 211 and inputting the resulting value to the adder 202, it is possible to reduce the number of skip digits plus 1 from the value of the counter 201. Thus, by obtaining the value of the number of all digits of input data from input data structure information 150 before start of division and setting the obtained value to the counter 201, it is possible to correctly decrement the number of digits of input data input to a divider circuit, which constantly obtains the number of remaining digits of input data on the counter 201. Also, the division remainder generation end decision circuit 212 can be used to determine the end of generation of division remainder.

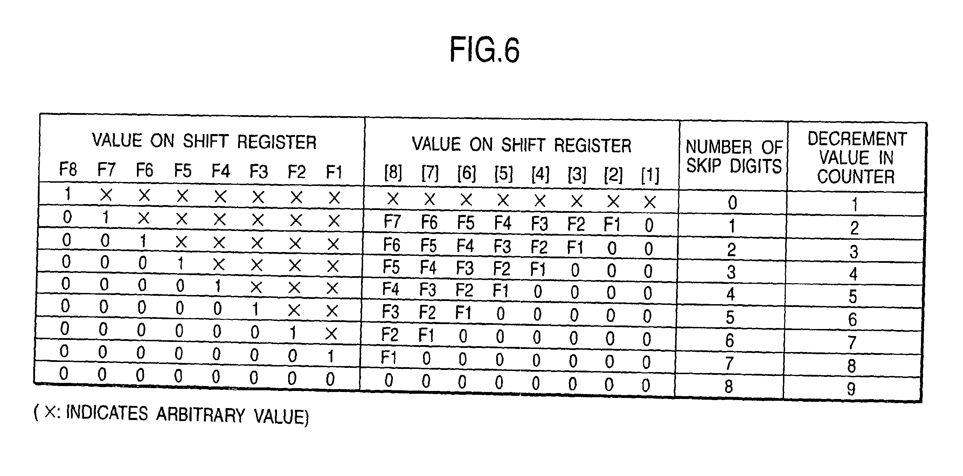

As shown in Fig. 6, the remainder shift circuit selects one of the seven values obtained by shifting the value of flip-flops F8 through F1 by one to seven digits, depending on the number of skip digits. This example shows that the number of digits of leading 0s on the shift register serves as the number of skip digits. In case the number of skip digits is equal to the number of digits of the shift register, the value on then shift register is all 0 for right digits, meaning that the subsequent input data is successive 0s in eight or more digits. Thus 8-digit 0s may be output from the remainder shift circuit or selector circuits 130 through 137 may select the output of each flip-flop.

The circuit for detecting the number of digits of leading 0s converts the detected value into a binary code for comparison of the detected data with another value. For example, in case a notation is used where the output of the flip-flop F8 is represented by F8 and the negation value thereof by F8, and so on, and the logical conjunction sign is represented by + to omit the logical inclusive disjunction sign, the logical expression of 4-bit binary codes S3 through S0 representing the number-of-digit detection value of leading 0s of the flip-flops F8 through F1 will be as shown below.

$$S3=F8'F7'F6'F5'F4'F3'F2'F1'$$

$$S2=F8'F7'F6'F5' (F4 + F3 + F2 + F1)$$

$$S1=F8'F7' (F6 + F5 + F4'F3' (F2 + F1)$$

$$S0=F8' (F7 + F6' (F5 +F4' (F3 + F2'F1)))$$

In case the input data is as shown in Fig. 4, to reduce the circuit in Fig. 2, the circuit 205 for detecting the number of digits of leading 0s is deleted from Fig. 2.

Then, instead of the output of the circuit 205 for detecting the number of digits of leading 0s, the value d is input into the comparator circuit 206 and 0 into the selector circuit 207. In case the value of the counter 201 is greater than d, 0 is selected. When the value of the counter 201 has dropped to d or below, the counter value is selected. In this way, the number of skip digits is 0 until the end of input of c-bit information data. After the end of input of c-bit information data, the necessary number of skip digits is obtained.

While the aforementioned embodiment is effective means for generating a division remainder in various coding procedures, the quotient of a division result may be used as ca codeword in certain encoding. In such a case, the quotient of the aforementioned division leaves the 0 of the number of skip digits dropped. Thus, a method for obtaining a correct quotient of division will be described.

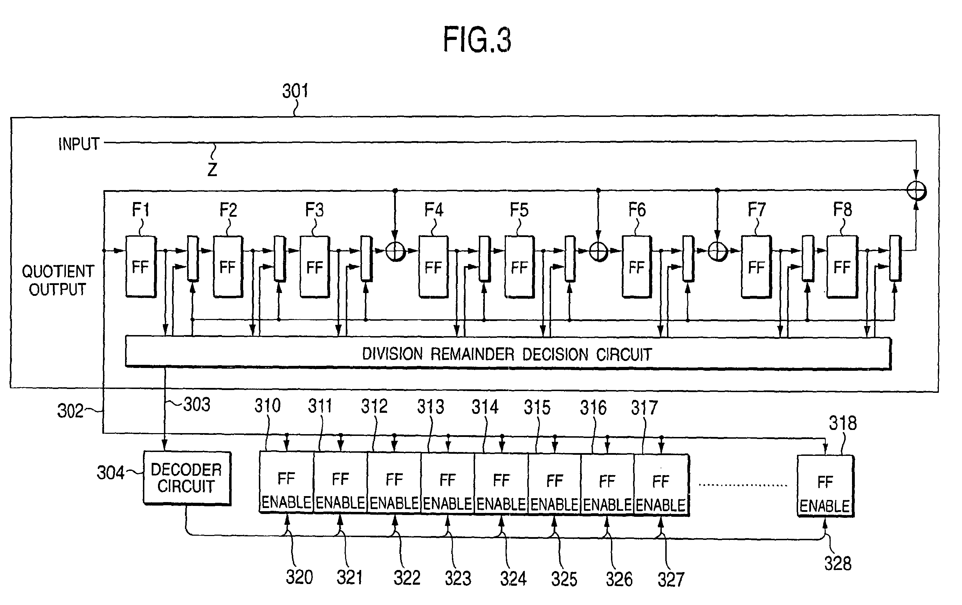

Fig. 3 is a circuit diagram showing a code generator circuit according to the second embodiment. This configuration gives a quotient of division in a code generator circuit according to the first embodiment. In Fig. 3, a numeral 301 represents a code generator circuit according to the first embodiment, 302 a quotient output signal from the code generator circuit 301, 303 an output from the counter 201, 304 a decoder circuit for decoding the value of the counter 201, 310 through 318 flip-flops comprising a register for storing the quotients of the division, 320 through 328 enable signal for individually controlling the input of the flip-flops 310 through 318.

The number of bits of the quotient of division in generating cyclic codes is equal to the number of input bits. Thus the output of the counter 201 representing the number of the remaining digits of input data shows the bit position where the quotient output is stored. First, the flip-flops 31-0 through 318 are reset to 0. Then the output of the counter 201 is decoded in the decoder circuit 304. The resulting outputs 320 through 328 are used to individually control the inputs of the flip-flops 310 through 318 to input the quotient output 303. This procedure inserts the quotient output and 0 of the number of skip digits into correct bit position and obtains the quotient of correct division on the flip-flops 310 through 318.

In the actual circuit configuration, the circuit scale is too large depending on the number of bits of input data. When the degree of the generator polynomial is bth, flip-flops of $2^{(n + 1)}$ bits where n is a natural number satisfying $2^n \geq b$ is provided. First, the flip-flops are reset to 0 and the decoder circuit 304 decodes the lower n + 1 bits of the output of the counter 201 and stores the quotient output into the flip-flop for the decoding section. The decoder stores into memory the quotient of the upper $2^n$ bits each time it is obtained, resets the n-bit flip-flops to 0, and replaces the position of the flip-flops for the upper $2^n$ bits with that of the flip-flops for the lower $2^n$ bits in order to alternate their roles. This configures a circuit that obtains a correct quotient in memory with small circuit scale.

In this way, it is possible to readily implement a code generator circuit that may possibly reduce the division time especially when the input data has a characteristic of including a great number of successive 0s. While a specific circuit configuration is shown as an embodiment in the foregoing description, individual circuits composing the embodiment are typical logic circuits and not limited to those in the foregoing description but a variety of circuit designs are possible without departing from the scope and spirit of the invention.

As described earlier, according to the invention, in a code generator circuit for performing division by using a generator polynomial, it is possible to reduce the division time, especially for the input data having a characteristic of including a great number of successive 0s, by obtaining the number of skip digits from the number of digits of leading 0s of the remainder in the middle of the division and the number of digits of leading 0s of the subsequent input data, and by skipping the simple shift processing not requiring division operation.

According to the invention, it is possible to obtain the quotient of correct division by knowing the bit position for the quotient output of a code generator circuit from the number of remaining digits and correctly inserting 0s of the number of skip digits into the skipped pit positions, even when simple shift processing not requiring division operation is skipped.

## Claims

1. A code generator circuit for dividing input data input to a bit serial by a predetermined generator polynomial to generate a division remainder, comprising:

   division means configured as a shift register where a plurality of flip-flops, selector circuits respectively added immediately before said flip flops, and exclusive-OR circuits inserted according to said generator polynomial are serially connected, and
   a remainder shift circuit for comparing the number of digits of leading 0s of the value on said shift register with the number of leading 0s of the subsequent input data, assuming the number of digits of the smaller as the number of skip digits, then outputting said value on the shift register shifted by said number of skip digits,

   wherein said selector circuits select the output of said remainder shift circuit when said number of skip digits is 1 or more and select the output of the flip-flops connected immediately before the respective selector circuits when said number of skip digits is 0.

2. Acode generator circuit according to claim 1 further comprising:

count means for counting the number of shifts of said shift register; and

decision means for detecting that said count means has counted said number of skip digits additionally in case said selector circuits have selected the output of said remainder shift circuit and detecting that said count means has counted up to a value equal to the total number of digits of said input data to terminate the generation of division remainder.

3. A code generator circuit according to claim 1 or 2, comprising storage means for storing the quotients obtained by dividing said input data by said generator polynomial,

wherein, in case said selector circuits have not selected the output of said remainder shift circuit, said code generator circuit sets the quotient output of said divider circuit to the digit position of said storage means corresponding to the digit position of said input data and, in case said selector circuits have selected the output of said remainder shift circuit, inserts 0s as many as the number of said skip digits than sets the quotient output of said divider circuit to the digit position of said storage means corresponding to the digit position of said input data.

# FIG.1

INPUT

Z

113

EP 1 337 044 A2

8

F1  130  F2  131  F3  132  F4  133  F5  134  F6  135  F7  136  F8  137

FF  FF  FF  FF  FF  FF  FF  FF

110  111  112

140

INPUT DATA
STRUCTURE
INFORMATION

DIVISION REMAINDER DECISION CIRCUIT

150

101

QUOTIENT OUTPUT

# FIG.2

8 BITS FROM HEAD
OF SUBSEQUENT
INPUT DATA

F8~F1

203

**CIRCUIT FOR DETECTING NUMBER OF DIGITS OF LEADING O's**

205

**CIRCUIT FOR DETECTING NUMBER OF DIGITS OF LEADING O's**

207 — **SELECTION** ← **COMPARISON**

206

204

**REMAINDER SHIFT CIRCUIT**

209 — **SELECTION** ← **COMPARISON** — 208

211

**COMPLEMENT OF 1**

210

**≠0 DETECTED**

202 — **ADDER**

201 — **COUNTER**

212 — **=0 DETECTED**

INPUT TO
SELECTOR
CIRCUITS

CONTROL SIGNAL
FOR SELECTOR
CIRCUITS

SIGNAL INDICATING
END OF GENERATION
OF DIVISION REMAINDER

9

# FIG.3

# FIG.4

c BITS 400        401  d BITS

| INFORMATION DATA | 0 .................. 0 |

CODING-TARGET DATA    a BITS

# FIG.5

## FIG.6

| VALUE ON SHIFT REGISTER | | | | | | | | VALUE ON SHIFT REGISTER | | | | | | | | NUMBER OF SKIP DIGITS | DECREMENT VALUE IN COUNTER |
|---|---|---|---|---|---|---|---|---|---|---|---|---|---|---|---|---|---|
| F8 | F7 | F6 | F5 | F4 | F3 | F2 | F1 | [8] | [7] | [6] | [5] | [4] | [3] | [2] | [1] | | |
| 1 | × | × | × | × | × | × | × | × | × | × | × | × | × | × | × | 0 | 1 |
| 0 | 1 | × | × | × | × | × | × | F7 | F6 | F5 | F4 | F3 | F2 | F1 | 0 | 1 | 2 |
| 0 | 0 | 1 | × | × | × | × | × | F6 | F5 | F4 | F3 | F2 | F1 | 0 | 0 | 2 | 3 |
| 0 | 0 | 0 | 1 | × | × | × | × | F5 | F4 | F3 | F2 | F1 | 0 | 0 | 0 | 3 | 4 |
| 0 | 0 | 0 | 0 | 1 | × | × | × | F4 | F3 | F2 | F1 | 0 | 0 | 0 | 0 | 4 | 5 |
| 0 | 0 | 0 | 0 | 0 | 1 | × | × | F3 | F2 | F1 | 0 | 0 | 0 | 0 | 0 | 5 | 6 |
| 0 | 0 | 0 | 0 | 0 | 0 | 1 | × | F2 | F1 | 0 | 0 | 0 | 0 | 0 | 0 | 6 | 7 |
| 0 | 0 | 0 | 0 | 0 | 0 | 0 | 1 | F1 | 0 | 0 | 0 | 0 | 0 | 0 | 0 | 7 | 8 |
| 0 | 0 | 0 | 0 | 0 | 0 | 0 | 0 | 0 | 0 | 0 | 0 | 0 | 0 | 0 | 0 | 8 | 9 |

( ×: INDICATES ARBITRARY VALUE)

EP 1 337 044 A2

# FIG.7

INPUT

Z

QUOTIENT OUTPUT

F1 F2 F3 F4 F5 F6 F7 F8

FF FF FF FF FF FF FF FF

700 701 702 703

EP 1 337 044 A2